# EUROPEAN PATENT SPECIFICATION

(11) **EP 0 800 178 B1**
(45) Date of publication and mention of the grant of the patent: **02.02.2005**
(21) Application number: 96830191.1
(22) Date of filing: 05.04.1996
(51) Int. Cl.: G11C 14/00

(54) **Auto-saving circuit for programming set-up elements in non-volatile memory devices**
Automatische Speichersicherungsschaltung zur Programmierung der Konfigurationszellen einer nichtflüchtigen Halbleiterspeicheranordnung
Circuit de sauvegarde automatique des éléments de configuration dans un dispositif de mémoire non-volatile

(43) Date of publication of application: 08.10.1997
(73) Proprietor: STMicroelectronics S.r.l., 20041 Agrate Brianza (Milano) (IT)
(72) Inventor: Pascucci, Luigi, 20099 Sesto S. Giovanni (MI) (IT)
(74) Representative: Botti, Mario

(56) References cited:
- EP-A- 0 666 572
- US-A- 3 676 717
- US-A- 5 379 249

## Description

### Field of application

The present invention relates to an auto-saving circuit for programming configuration elements in non-volatile memory devices.

Specifically but not exclusively the present invention concerns a circuit for protecting from accidental changes configuration elements of non-volatile memory cells organized in a cells matrix in a memory device integrated on a semiconductor with said circuit being inserted between a first and a second reference power supply voltage and being powered also by programming voltages generated inside the memory device to produce at output programming signals of said configuration devices.

### Prior art

As known, in the provision of non-volatile memory devices, e.g. of the EPROM and flash EPROM type, there are used certain techniques to obviate the low yield of the production process.

These techniques consist of providing the cells matrix with additional rows or columns - termed redundant - which can be used to replace defective rows or columns which display malfunctions subsequent to testing of the memory device.

The function of the redundant elements is basic for the reliability of the memory device.

Those skilled in the art know the design methodology and the use of redundant rows and columns, of trimming networks and propagation control and of UPROM cells and the related selection circuitry. The latter allows readdressing the memory in such a manner as to replace the addresses containing defective bits with those containing functioning bits present in the redundant rows or columns.

For example, a UPROM cell is programmed in the testing phase, i.e. at the time the memory devices are subjected to an EWS (Electrical Wafer Sort). Before performing any kind of operation on the memory device the cells of the UPROM circuitry which will permit correctly addressing the memory addresses to be replaced are read.

The redundant elements are necessarily of the non-volatile type and are divided in two large groups, i.e. those modifiable as needed, e.g. EEPROM, and those modifiable only once such as for example electrically programmable fuses, PROM cells, etc.

The redundant elements thus allow reconfiguration of a non-volatile memory displaying malfunctions and in the following description they are defined as configuration elements. It is clear however that to fulfill their function the configuration elements must be whole and not display defects in turn.

It may happen that such configuration elements undergo accidental modifications due to undesired and unforeseeable events such as for example falls or overshoots of the power supply voltage or electrostatic discharges. These phenomena are known as 'soft writing' of the configuration elements, for example the UPROM cells.

It is clear that if a configuration element of the modifiable only once type is damaged by an electrostatic discharge the characteristics of the related memory device can even be modified permanently and its functionality is compromised.

There then arises the requirement to give a particular protection to the configuration elements and, specifically, to the circuitry assigned to their modification or programming.

A non-volatile flip-flop memory cell in which an alterable threshold voltage non volatile MNOS transistor is connected to each bistable terminal of the memory device is disclosed in the US Patent No. 3,676,717 to Lockwood. In particular, when a power failure is sensed, a high negative potential is applied to the gates of the MNOS transistors to change its threshold, thus retaining the state of the flip-flop circuit in the MNOS transistors.

The technical problem underlying the present invention is to conceive an auto-saving circuit for configuration elements of non-volatile memory cells with this circuit having structural and functional characteristics such as to allow adequate protection of the configuration elements from accidental events which could compromise their status and functionality.

This would allow overcoming the limitations and shortcomings of the solutions proposed by the prior art for memory devices produced currently.

An auto-saving circuit according to the preamble of claim 1 is known from US-A-5 379 249.

### Summary of the invention

The above technical problem is solved by a circuit of the type indicated above and defined in the characterizing part of the annexed claims 1.

The characteristics and advantages of the method in accordance with the present invention are set forth in the description of an embodiment thereof given below by way of non-limiting example with reference to the annexed drawings.

### Brief description of the drawings

FIG. 1 shows a diagrammatic view of an auto-saving circuit provided in accordance with the present invention for the programming of configuration elements in a non-volatile memory device,
FIG. 2 shows a diagrammatic view of a second embodiment of the circuit in accordance with the present invention,
FIG. 3 shows a diagrammatic view of a variant embodiment of the circuit of FIG. 1, and
FIG. 4 shows a diagrammatic view of a variant embodiment of the circuit of FIG. 2.

### Detailed description

With reference to the figures reference number 1 indicates as a whole and diagramatically the structure of an auto-saving circuit provided in accordance with the present invention for the programming of configuration elements in a non-volatile memory device.

The circuit is integrated in a flash semiconductor memory device which is not shown in the drawings but is to be understood of the type comprising a memory cells matrix organized in rows and columns. With the matrix is associated a conventional control, selection and decoding circuit.

The configuration elements for which the circuit 1 is designed can be of various types. However, for the sake of simplicity, in the description below these elements are identified with UPROM redundant cells of conventional structure and inserted between a first reference power supply voltage Vcc and a second reference voltage GND, for example a signal ground.

It is useful to recall briefly and in general terms the typical structure of a UPROM cell. It normally comprises a memory element represented by a floating-gate cell of the EPROM or flash type which contains a binary code of an address to be redounded. This floating-gate cell has a conduction terminal, the source terminal, directly connected to ground, while another conduction terminal, drain, is connected to the reference power supply voltage Vcc through a complementary pair of MOS transistors.

One of the transistors of the complementary pair is connected to the drain terminal of the floating-gate cell in a configuration with source follower. On the control gate of the cell is applied a UPR-CG signal while on the control terminal of the above mentioned transistor is applied a UPR-PG signal.

The circuit 1 in accordance with the present invention is assigned to generation of the programming signals UPR-CG and UPR-PG.

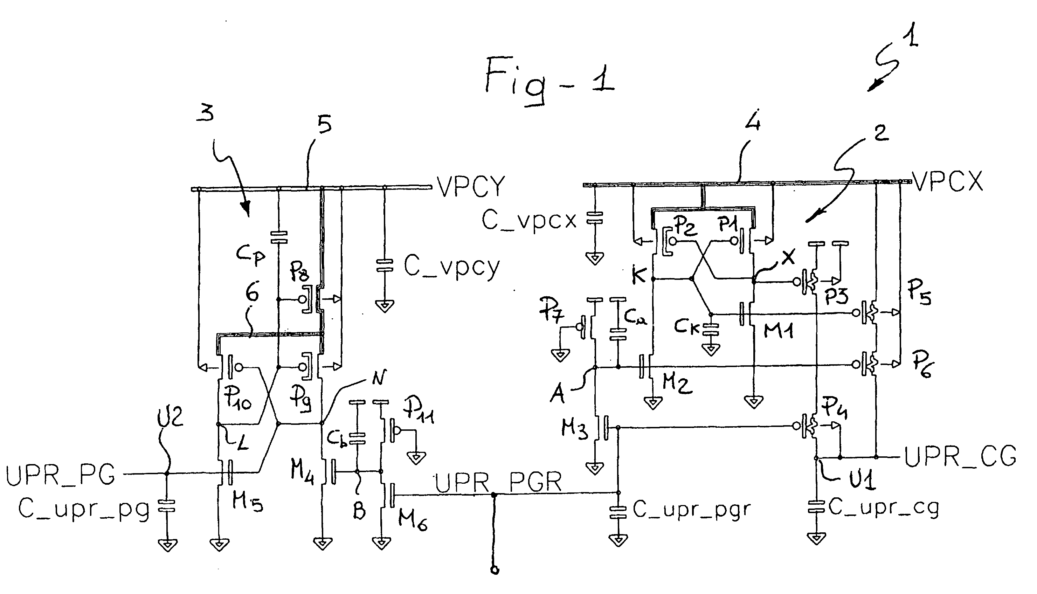

With particular reference to the example of FIG. 1 the circuit 1 comprises a first 2 and a second circuit portion 3. The portions 2 and 3 are powered by respective and distinct power supply voltages.

In particular, the first portion 2 is inserted between a power supply line 4 with voltage Vpcx and the ground GND. Between the line 4 and ground is inserted a natural capacitor C-vpcx for protection from power supply jumps.

The voltage Vpcx is generated inside the memory device to power the rows of the cells matrix in the programming phase.

The second portion 3 is inserted between a power supply line 5 with voltage Vpcy and ground GND. Between the line 5 and ground is inserted a natural capacitor C-vpcy for protection from power supply jumps.

The voltage Vpcy is generated in turn inside the memory device to power in the decoding phase the control terminals of the selection transistors present on the column of the cells matrix.

The voltages Vpcx and Vpcy are generated from a programming voltage Vpp supplied from outside the memory device. The circuit 1 is also connected to a reference power supply voltage Vdd.

The first portion 2 comprises a switching network with transistors incorporating centrally two complementary pairs of transistors with crossed connection.

A first pair comprises a transistor P1 of the PMOS type connected to the line 4 which has Vpcx voltage and a transistor M1 of the NMOS type connected to ground GND.

The second pair comprises a transistor P2 of the natural PMOS type with high threshold and connected to the line 4 which has Vpcx voltage and a transistor M2 of the NMOS type connected to ground GND.

The PMOS transistors of the first and second pair have their respective body terminals connected to the power supply Vpcx, that is to line 4.

The interconnection point X between the transistors P1 and M1 of the first pair is connected to the control terminal of the transistor P2 of the second pair. An analogous connection is provided between an interconnection node K of the second pair P2, M2 and both the control terminals of the transistors P1 and M1 of the first pair.

A decoupling capacitor Ck is inserted between the node K and ground.

The portion 2 also comprises the series of two high-resistance PMOS transistors P3 and P4 inserted between the reference power supply voltage Vdd and an output terminal U1. Between the output terminal U1 and ground there is a capacitor C-upr-cg. On the output terminal U1 is produced the signal UPR-CG.

The first P3 of these transistors is in diode configuration with the body terminal connected to the power supply and also displays the control terminal connected to the node X.

The second transistor P4 has its body terminal connected to the output terminal U1 and its control terminal connected to the control terminal of an NMOS transistor M3 having its source grounded. The latter control terminal receives a UPR-PGR activation signal and is connected to ground through a capacitor C-upr-prg.

The transistor M3 forms a third complementary pair with a PMOS transistor P7 connected to the reference voltage Vdd and having its control terminal connected to ground.

The interconnection node A between the transistors M3 and P7 coincides with the control terminal of the transistor M2 of the second complementary pair. Between the node A and the reference voltage Vdd is provided a rise-up capacitor Ca.

The structure of the circuit portion 2 is completed by a pair of transistor P5 and P6 connected in series together in diode configuration between the line 4 and the output terminal U1. The control terminal of the transistor P5 is in common with that of the transistor M1 driven by the node K while the control terminal of the transistor P6 is in common with that of the transistor M2 driven by the node A.

The second circuit portion 3 is now discussed in detail.

This portion, too, comprises a network of transistors with a double complementary pair arranged centrally.

A first complementary pair comprises a PMOS transistor P10 connected to a line 6 branched from the line 5 having voltage Vpcy and an NMOS transistor M5 connected to ground GND. The line 6 is connected to the line 5 through a transistor P8 of the natural PMOS type with high threshold and also having its body terminal connected to the line 5.

A decoupling capacitor Cp is inserted between the line 5 and the control terminal of the transistor P8.

The second complementary pair comprises a transistor P9 of the natural PMOS type with high threshold and connected to the line 6 and a transistor M4 of the NMOS type connected to ground GND.

The PMOS transistors of the first and second pair have their respective body terminals connected to the power supply Vpcy, i.e. to the line 5.

The interconnection point L between the transistors P10 and M5 of the first pair is connected both to the control terminal of the transistor P9 of the second pair and to the control terminal of the transistor P8. An analogous connection is provided between an interconnection node N of the second pair P9, M4 and both the control terminals of the transistors P10 and M5 of the first pair.

The portion 3 comprises an output terminal U2 which coincides virtually with the control terminal of the transistor M5. On the output terminal U2 is produced the signal UPR-PG. Between the output terminal U2 and ground there is a capacitor C-upr-pg.

The control terminal of the transistor M4 is driven by the output node B of a third complementary pair made up of an NMOS transistor M6 having its source grounded and of a transistor P11 of the PMOS type connected to the reference power supply voltage Vdd and having its control terminal connected to ground. Between the node B and the reference voltage Vdd there is provided a rise-up capacitor Cb.

On the control terminal of the transistor M6 is applied the activation signal UPR-PGR.

There is now described the operation of the circuit 1 in accordance with the present invention starting from an initial state in which on the node K is present a low logical value.

Under these conditions the capacitor Ca is charged at the voltage Vdd to take to a high logical value the node A which extinguishes the transistor P6. At the same time there is also taken high the node X to extinguish both the natural PMOS transistor P2 and the transistor P3.

The output terminal U1 is therefore held low by the coupling to ground of the capacitor C-upr-cg. The transistor P7 with its control terminal grounded immediately conducts and keeps the value of the node A high.

The network of transistors thus automatically deactivates the output U1 which can switch only when there is reached a relatively high voltage value by the activation signal UPR-PGR. This signal must have a value higher than the power supply Vdd.

The circuit portion 3 of the circuit 1 operates in a manner analogous to the above portion 2. When the node N has a low logical value the capacitor Cb is charged at the voltage Vdd to take to a high logical value the node B which takes high the node L to extinguish both the natural PMOS transistor P9 and the transistor P8.

The output node U2 is therefore kept low by the coupling to ground of the capacitor C-upr-pg. The transistor P11 with its control terminal grounded conducts immediately and keeps high the value of the node B.

The network of transistors of the circuit portion 3 automatically deactivates the output U2 which can switch only when there is reached a relatively high voltage value by the activation signal UPR-PGR. To free itself from this low value the node U2 must overcome two thresholds of natural PMOS transistors such as the transistors P8 and P9.

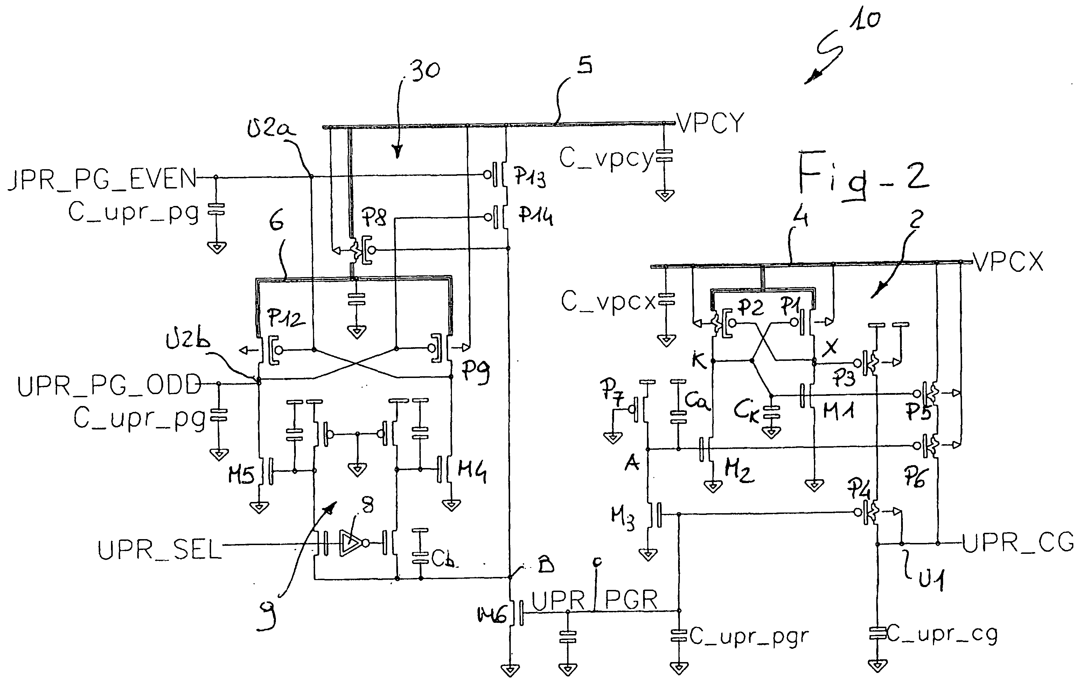

Now, with particular reference to the example of FIG. 2 there is described a second embodiment of the circuit 1 in accordance with the present invention. In this example cooperating details and parts having the same structure and operation as the previous embodiment are indicated by the same reference numbers and symbols.

In FIG. 2 the circuit in accordance with the present invention is indicated by reference number 10 since only the first circuit portion 2 has remained unchanged.

The second circuit portion is indicated by reference number 30 and is structured in such a manner as to produce two distinct output signals, UPR-PG-EVEN and UPR-PG-ODD on respective output terminals U2a and U2b.

The portion 30 is susceptible of receiving another input signal UPR-SEL which allows selection of a right or left portion of configuration elements to be programmed.

The signal UPR-SEL is applied to the input of an inverter 8 incorporated in a voltage booster block 9.

The block 9 is inserted between the respective control terminals of the transistors M5 and M4 of the first and second complementary pair incorporated centrally in the second circuit portion 30.

The booster block 9 comprises in turn two complementary pairs of transistors.

Each pair comprises a PMOS transistor connected to the reference voltage Vdd and an NMOS transistor connected to the drain terminal of the transistor M6. The PMOS transistors of the first and second pair have their respective control terminals grounded.

Between the control terminals of the NMOS transistors of the first and second pairs is inserted the inverter 8.

The interconnection point between the PMOS and NMOS transistors of the first pair is connected to the control terminal of the transistor M5. The interconnection point between the PMOS and NMOS transistors of the second pair is connected to the control terminal of the transistor M4.

Between each control terminal of the transistors M5 and M4 and the power supply Vdd is inserted a capacitive coupling.

With respect to the second circuit portion 3 of the above embodiment the portion 30 calls for a PMOS transistor P12 of the natural type with high threshold instead of the transistor P10 in the first complementary pair.

On the control terminal of the transistor P12 is taken the output U2a.

The second output U2b of the portion 30 coincides with the control terminal of the transistor P9 of the second complementary pair.

The outputs U2a and U2b are also connected to respective control terminals of two pull-up PMOS transistors P13 and P14 connected between the Vpcy power supply line 5 and the node B which coincides with the drain terminal of the transistor M6.

Very briefly, the signal UPR-SEL activates and deactivates alternately the branches of the circuit portion 30.

In the block 9 the value of ground is not set at the output nodes of the booster so that through the coupling capacitors present on the control terminals of the transistors M5 and M4 these nodes can rise towards Vdd.

The node B is drawn towards Vpcy by the two pull-ups P13 and P14 and must overcome the resistance of these transistors to allow emission at output of a programming signal. The node B tends naturally to extinguish the natural resistive transistor P8 which connects the lines 5 and 6.

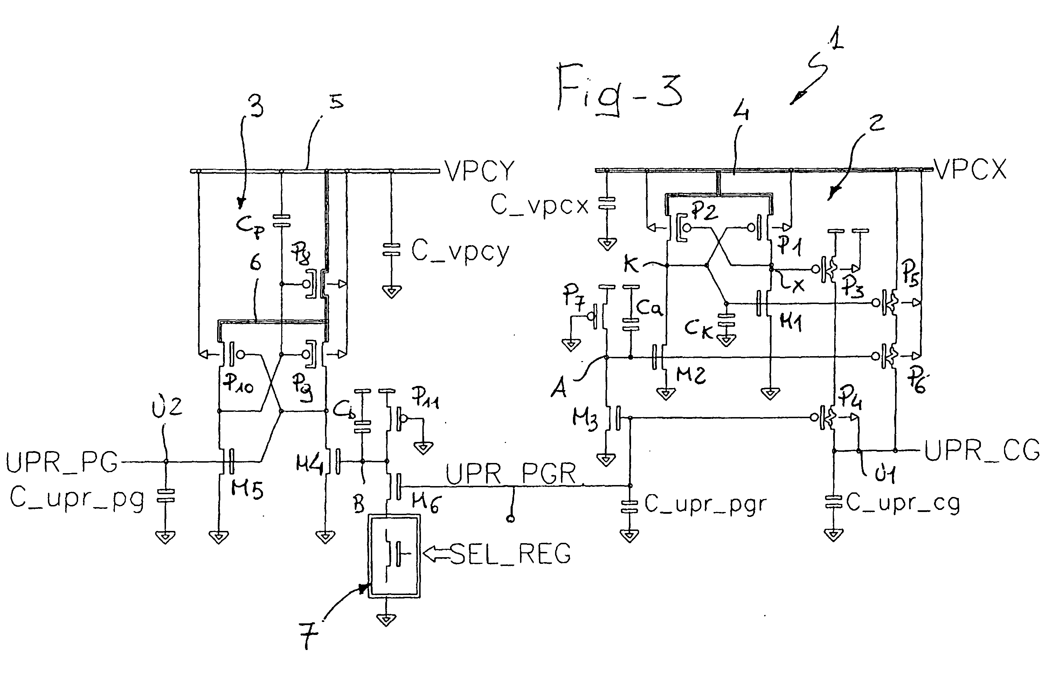

FIG. 3 shows a variant embodiment of the circuit 1 in accordance with the present invention in which there has been provided the presence of a register selector 7 connected in series with the transistor M6.

This variant finds a field of application in all cases in which the configuration elements to which the circuit is dedicated are contained in registers addressable by groups.

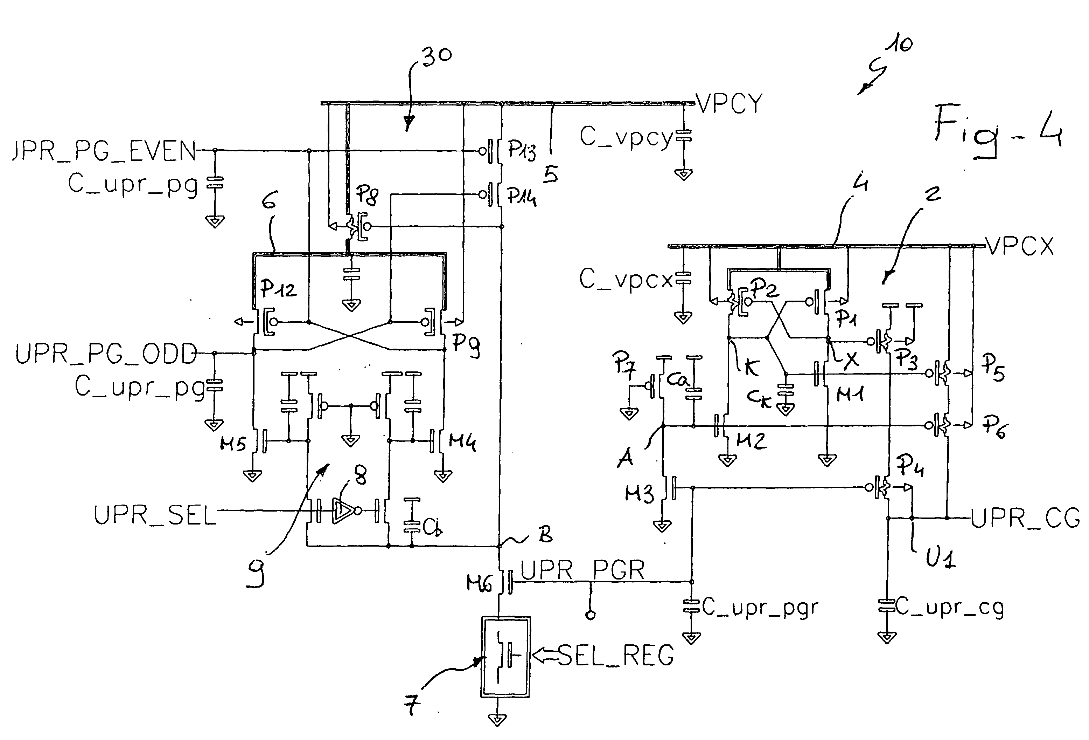

FIG. 4 shows diagramatically an embodiment variant of the circuit of FIG. 2. Basically, the selector 7 of FIG. 3 has also been inserted in the circuit structure of the example of FIG. 2.

From the above considerations it is clear that the auto-saving circuit in accordance with the present invention solves the technical problem in a simple and effective manner to achieve numerous advantages.

In the first place, the circuits are powered by Vpcx and Vpcy voltage lines having filtering characteristics with respect to spurious power supply signals directed towards the memory matrix.

In the second place, the entire structure of the circuit 1 proves to be poorly reactive towards accidental and undesired modifications of the power supply voltage values. Basically, the circuit shows decided inertia to any type of sudden change.

The configuration of the circuit 1 is such that it shows a natural tendency to reach the state of deactivation.

The loads present in the circuit are intentionally weighted to achieve the above mentioned inertia.

The protective elements provided in the circuit in accordance with the present invention prevent dangerous overvoltages due to electrostatic discharges. There is no longer the risk of altering the information contained in the configuration elements, for example the UPROM cells, following a spurious programming of these elements.

Overall, the circuit in accordance with the present invention has auto-saving characteristics which consent avoidance of dangerous modifications of the configuration elements of the memory matrix.

It can be stated that the circuit in accordance with the present invention achieves better protection of the programming circuits of the configuration elements thanks to the 'cascade' architecture of the power supply lines and to the inertia characteristics towards spurious switching signals.

## Claims

1. Auto-saving circuit for programming configuration elements of non-volatile memory cells organized in a cells matrix in a memory device integrated on a semiconductor with said circuit being inserted between a first (Vdd) and a second (GND) power supply reference voltage and being powered also by a first and a second programming voltage (Vpcx,Vpcy) generated inside the memory device to produce at output a first and a second programming signal (UPR-CG,UPR-PG) for said configuration elements and **characterized in that** it comprises:
- a first (2) circuit portion, having a first signal output (U1), powered by said first programming voltage (Vpcx) and comprising a first switching network comprising two complementary pairs of transistors (P1,M1; P2,M2) with crossed connections, said one first complementary pair comprising a transistor (P1) of the PMOS type powered by the first programming voltage (Vpcx) and a transistor (M1) of the NMOS type connected to the second reference voltage (GND) while the second pair comprises a transistor (P2) of the natural PMOS type with high threshold and powered by the same programming voltage (Vpcx) and a transistor (M2) of the NMOS type connected to said second reference (GND) and further comprising at least a further pair of transistors (P5,P6) of the resistive PMOS type connected in series with said first programming voltage (Vpcx) and the output (U1) of the first portion (2) with the control terminal of one (P5) of said transistors being connected to the interconnection point (K) of the second complementary pair (P2,M2) thereby generating said first programming signal (UPR-CG) to said first signal output (U1) by transfering said first programming voltage (Vpcx) throught said further pair of transistors (P5,P6);
- a second (3) circuit portion, having a second signal output (U2), powered by said second programming voltage (Vpcy) and comprising a second switching network comprising two complementary pairs of transistors (P10,M5; P9,M4) with crossed connections, said first complementary pair comprises a transistor (P10) of the PMOS type powered by the second programming voltage (Vpcy) and a transistor (M5) of the NMOS type connected to the second reference voltage (GND) while the second pair comprises a transistor (P9) of the natural PMOS type with high threshold and powered by the same programming voltage (Vpcy) and a transistor (M4) of the NMOS type connected to said second reference (GND) thereby generating said first programming signal (UPR-PG) to said second signal output (U2) by transfering said second programming voltage (Vpcy) from the connection point between the transistors of said second pair to said second signal output (U2),
- decoupling elements (Ca,Cb,Ck,Cp) coupled between the gates of the NMOS type transistors and the first or second reference voltage to give inertia to the circuit towards electrostatic discharges or accidental variations in the power supplies.

2. Circuit in accordance with claim 1 and **characterized in that** the interconnection point (X) between the transistors (P1,M1) of the first pair is connected to the control terminal of the transistor (P2) of the second pair and that an analogous connection is provided between an interconnection node (K) of the second pair (P2,M2) and both the control terminals of the transistors (P1,M2) of the first pair.

3. Circuit in accordance with claim 1 and **characterized in that** it comprises a third complementary pair (M3,P7) of transistors receiving at input a programming enablement signal (UPR-PGR) and having an output node (A) connected to the control terminal of the second transistor (M2) of the second pair.

4. Circuit in accordance with claim 1 and **characterized in that** it comprises at least one pair of transistors (P3,P4) of the resistive PMOS type connected in series between the first reference voltage (Vdd) and the output (U1) of the first portion (2) with the control terminal of one (P3) of said transistors being connected to the interconnection point (X) of the first complementary pair.

5. Circuit in accordance with claim 1 and **characterized in that** between the output node (A) of said third complementary pair and the first reference voltage (Vdd) is inserted a capacitor (Ca).

6. Circuit in accordance with claim 1 and **characterized in that** it comprises a capacitor (C-vpcx,C-vpcy) for protection from overshoots between each programming line (4,5) and a signal ground (GND).

## Patentansprüche

1. Schaltung zur automatischen Sicherungsspeicherung für die Programmierung von Konfigurationselementen bei nicht-flüchtigen Speicherzellen, welche in einer Zellenmatrix in einer Speichervorrichtung organisiert sind, die auf einem Halbleiter integriert ist, wobei die Schaltung zwischen einer ersten (Vdd) und einer zweiten (GND) Stromversorgungs-Referenzspannung eingesetzt ist und auch mit einer ersten und einer zweiten Programmierspannung (Vpcx, Vpcy) versorgt wird, welche innerhalb der Speichervorrichtung erzeugt wird, um am Ausgang ein erstes und ein zweites Programmiersignal (UPR-CG, UPR-PG) für die Konfigurationselemente zu bilden, **dadurch gekennzeichnet, dass** sie folgendes aufweist:
- einen ersten Schaltungsbereich (2) mit einem ersten Signalausgang (U1), welcher mit der ersten Programmierspannung (Vpcx) versorgt wird und ein erstes Schaltnetzwerk umfasst, welches zwei komplementäre Paare von Transistoren (P1, M1; P2, M2) mit überkreuzten Verbindungen aufweist, wobei ein erstes komplementäres Paar einen Transistor (P1) vom PMOS-Typ, der mit der ersten Programmierspannung (Vpcx) versorgt wird, und einen Transistor (M1) vom NMOS-Typ aufweist, welcher mit der zweiten Bezugsspannung (GND) verbunden ist, wohingegen das zweite Paar einen Transistor (P2) vom natürlichen PMOS-Typ mit hoher Schwelle, der mit der gleichen Programmierspannung (Vpcx) versorgt wird, und einen Transistor (M2) von NMOS-Typ aufweist, welcher mit der zweiten Bezugsspannung (GND) verbunden ist, und wobei das Schaltnetzwerk des Weiteren mindestens ein weiteres Paar Transistoren (P5, P6) vom ohmschen PMOS-Typ aufweist, welche in Reihe zu der ersten Programmierspannung (Vpcx) geschaltet sind, und wobei der Ausgang (U1) des ersten Schaltungsbereichs (2) mit dem Steueranschluss eines (P5) der Transistoren mit dem Verbindungspunkt (K) des zweiten komplementären Paars (P2, M2) verbunden ist, wodurch das erste Programmiersignal (UPR-CG) erzeugt und zum ersten Signalausgang (U1) übertragen wird, indem die erste Programmierspannung (Vpcx) über das weitere Paar Transistoren (P5, P6) übertragen wird;
- einen zweiten Schaltungsbereich (3) mit einem zweiten Signalausgang (U2), welcher mit der zweiten Programmierspannung (Vpcy) versorgt wird, welcher ein zweites Schaltnetzwerk umfasst, das zwei komplementäre Paare von Transistoren (P10, M5; P9, M4) mit überkreuzten Verbindungen aufweist, wobei das erste komplementäre Paar einen Transistor (P10) vom PMOS-Typ, der mit der zweiten Programmierspannung (Vpcy) versorgt wird, und einen Transistor (M5) vom NMOS-Typ aufweist, welcher mit der zweiten Bezugsspannung (GND) verbunden ist, wohingegen das zweite Paar einen Transistor (P9) vom natürlichen PMOS-Typ mit hoher Schwelle, welcher mit der gleichen Programmierspannung (Vpcy) versorgt wird, und einen Transistor (M4) vom NMOS-Typ aufweist, welcher mit der zweiten Bezugsspannung (GND) verbunden ist, wodurch das erste Programmiersignal (UPR-PG) erzeugt und zum zweiten Signalausgang (U2) übertragen wird, indem die zweite Programmierspannung (Vpcy) vom Verbindungspunkt zwischen den Transistoren des zweiten Paares zum zweiten Signalausgang (U2) übertragen wird;
- Entkoppelelemente (Ca, Cb, Ck, Cp), die zwischen den Gattern der Transistoren vom NMOS-Typ und der ersten oder zweiten Bezugsspannung so eingekoppelt sind, dass der Schaltung eine Trägheit gegenüber elektrostatischen Entladungen oder gegenüber zufälligen Schwankungen in den Stromversorgungen verliehen wird.

2. Schaltung nach Anspruch 1, **dadurch gekennzeichnet, dass** der Verbindungspunkt (X) zwischen den Transistoren (P1, M1) des ersten Paares mit dem Steueranschluss des Transistors (P2) des zweiten Paares verbunden ist, und dass eine analoge Verbindung zwischen einem Verbindungsknoten (K) des zweiten Paares (P2, M2) und beiden Steueranschlüssen der Transistoren (P1, M1) des ersten Paares vorgesehen ist.

3. Schaltung nach Anspruch 1, **dadurch gekennzeichnet, dass** sie ein drittes komplementäres Paar (M3, P7) von Transistoren aufweist, welches am Eingang ein Signal (UPR-PGR) zur Freigabe der Programmierung empfängt und dessen Ausgangsknoten (A) mit dem Steueranschluss des zweiten Transistors (M2) des zweiten Paares verbunden ist.

4. Schaltung nach Anspruch 1, **dadurch gekennzeichnet, dass** sie mindestens ein Paar von Transistoren (P3, P4) vom ohmschen PMOS-Typ aufweist, welche zwischen der ersten Bezugsspannung (Vdd) und dem Ausgang (U1) des ersten Schaltungsbereichs (2) in Reihe geschaltet ist, wobei der Steueranschluss des einen (P3) der Transistoren mit dem Verbindungspunkt (X) des ersten komplementären Paares verbunden ist.

5. Schaltung nach Anspruch 1, **dadurch gekennzeichnet, dass** zwischen dem Ausgangsknoten (A) des dritten komplementären Paares und der ersten Bezugsspannung (Vdd) ein Kondensator (Ca) eingesetzt ist.

6. Schaltung nach Anspruch 1, **dadurch gekennzeichnet, dass** sie einen Kondensator (C-vpcx, C-vpcy) zum Schutz vor Überschwingungen zwischen jeder Programmierzeile (4, 5) und einer Betriebserde (GND) aufweist.

## Revendications

1. Circuit de sauvegarde automatique pour la programmation d'éléments de configuration de cellules de mémoire non volatiles organisées sous la forme d'une matrice de cellules dans un dispositif de mémoire intégré sur un semiconducteur, ledit circuit étant inséré entre une première tension de référence d'alimentation en énergie (Vdd) et une seconde tension de référence d'alimentation en énergie (GND) et étant alimenté par des première et seconde tensions de programmation (Vpcx, Vpcy) produites à l'intérieur du dispositif de programmation pour produire, à la sortie, des premier et second signaux de programmation (UPR-CG, UPR-PG) pour lesdits éléments de configuration et **caractérisé en ce qu'**il comprend:
- une première partie de circuit (2) possédant une première sortie de signal (U1) alimentée par ladite première tension de programmation (Vpcx) et comprenant un premier réseau de commutation comprenant deux paires complémentaires de transistors (P1,M1; P2,M2) avec des connexions croisées, ladite une première paire complémentaire comprenant un transistor (P1) du type PMOS alimenté par la première tension de programmation (Vpcx) et un transistor (M1) du type NMOS connecté à la seconde tension de programmation (GND) tandis que la seconde paire comprend un transistor (P2) du type PMOS naturel possédant un seuil élevé et alimenté par la même tension de programmation (Vpcx) et un transistor (M2) du type NMOS connecté à ladite seconde tension (GND), et comprenant en outre une autre paire de transistors (P5, P6) du type PMOS résistif, connectés en série avec ladite première tension de programmation (Vpcx) et avec la sortie (U1) de la première partie (2), la borne de commande de l'un (P5) desdits transistors étant connectée au point d'interconnexion (K) de la seconde paire complémentaire (P2, M2) de manière à envoyer ledit premier signal de programmation (UPR-CG) à ladite première sortie de signal (U1) par transfert de ladite première tension de programmation (Vpcx) par l'intermédiaire de ladite autre paire de transistors (P5, P6);
- une seconde partie de circuit (3) comportant une seconde sortie de signal (U2), alimentée par ladite seconde tension de programmation (Vpcy) et comprenant un second réseau de commutation comprenant deux paires complémentaires de transistors (P10, M5; P9, M4) avec des connexions croisées, ladite première paire complémentaire comprenant un transistor (P10) du type PMOS alimenté par la seconde tension de programmation (Vpcy) et un transistor (M5) du type NMOS connecté à la seconde tension de référence (GND), tandis que la seconde paire comprend un transistor (P9) du type PMOS naturel avec un seuil élevé et alimenté par la même tension de programmation (Vpcy) et un transistor (M4) du type NMOS connecté à ladite seconde référence (GND) de manière à envoyer ledit premier signal de programmation (UPR-PG) à ladite seconde sortie de signal (U2) par transfert de ladite seconde tension de programmation (Vpcy) à partir du point de connexion entre les transistors de ladite seconde paire à ladite seconde sortie de signal (U2),
- des éléments de découplage (Ca, Cb, Ck, Cp) couplés entre les grilles des transistors de type NMOS et la première ou seconde tension de référence pour appliquer une inertie au circuit en direction de décharges électrostatiques ou de variations accidentelles dans les sources d'alimentation.

2. Circuit selon la revendication 1 et **caractérisé en ce que** le point d'interconnexion (X) entre les transistors (P1, M1) de la première paire est connecté à la borne de commande du transistor (P2) de la seconde paire et qu'une connexion analogique est prévue entre un noeud d'interconnexion (K) de la seconde paire (P2, M2) et les deux bornes de commande des transistors (P1, M1) de la première paire.

3. Circuit selon la revendication 1 et **caractérisé en ce qu'**il comprend une troisième paire complémentaire (M3, P7) de transistors recevant, au niveau de l'entrée, un signal de validation de programmation (UPR-PGR) et comportant un noeud de sortie (A) connecté à la borne de commande du second transistor (M2) de la seconde paire.

4. Circuit selon la revendication 1 et **caractérisé en ce qu'**il comprend au moins une paire de transistors (P3, P4) du type PMOS résistif connectés en série entre la première tension de référence (Vdd) et la sortie (U1) de la première partie (2), la borne de commande de l'un (P3) desdits transistors étant connectée au point d'interconnexion (X) de la première paire complémentaire.

5. Circuit selon la revendication 1 et **caractérisé en ce qu'**entre le noeud de sortie (1) de ladite troisième paire complémentaire et la première tension de référence (Vdd) est inséré un condensateur (Ca).

6. Circuit selon la revendication 1 et **caractérisé en ce qu'**il comprend un condensateur (C-vpcx, C-vpcy) pour réaliser une protection vis-à-vis de dépassements de modulation entre chaque ligne de programmation (4, 5) et une masse (GND) pour le signal.
